Europäisches Patentamt

European Patent Office

Office européen des brevets

(19)

(11) **EP 0 981 440 B1**

(12) **EUROPÄISCHE PATENTSCHRIFT**

(45) Veröffentlichungstag und Bekanntmachung des Hinweises auf die Patenterteilung:
**16.01.2002 Patentblatt 2002/03**

(21) Anmeldenummer: **98928225.6**

(22) Anmeldetag: **04.05.1998**

(51) Int Cl.⁷: **B32B 27/18**, B32B 15/08, B32B 27/32, B65D 65/40, B32B 31/00

(86) Internationale Anmeldenummer:
**PCT/EP98/02619**

(87) Internationale Veröffentlichungsnummer:
**WO 98/51494 (19.11.1998 Gazette 1998/46)**

(54) **MEHRSCHICHTIGE, GERECKTE, HEISSSIEGELBARE IM VAKUUM BEDAMPFTE POLYPROPYLENFOLIE**

MULTI-LAYER, DRAWN, HEAT-SEALABLE, VACUUM-PLATED POLYPROPYLENE FILM

FILM POLYPROPYLENE MULTICOUCHE, ETIRE, THERMOSOUDABLE ET METALLISE AU VIDE

(84) Benannte Vertragsstaaten:
**AT BE CH DE ES FR GB IT LI LU NL**

(30) Priorität: **15.05.1997 DE 19720313**

(43) Veröffentlichungstag der Anmeldung:
**01.03.2000 Patentblatt 2000/09**

(73) Patentinhaber: **Wolff Walsrode AG
29655 Walsrode (DE)**

(72) Erfinder:
• **BRANDT, Rainer
D-29664 Walsrode (DE)**
• **GERNOT, Thomas
D-27283 Verden (DE)**
• **SCHWARZ, Willi
D-29699 Bomlitz (DE)**
• **EINENKEL, Harald
D-29664 Walsrode (DE)**

(74) Vertreter: **Pettrich, Klaus-Günter, Dr.
c/o Bayer AG, Konzernbereich RP Patente und Lizenzen
51368 Leverkusen (DE)**

(56) Entgegenhaltungen:
EP-A- 0 282 917    EP-A- 0 329 336
EP-A- 0 461 820    EP-A- 0 477 797
EP-A- 0 481 344

**Beschreibung**

Die Erfindung betrifft eine im Vakuum mit Aluminium bedampfte mehrschichtige, biaxial gereckte, heißsiegelbare, Polypropylenfolie mit guter Verklebbarkeit und geringer Pinholeanzahl der Aluminiumschicht und darausfolgend guter Sperrwirkung gegen Wasserdampf, Sauerstoff und Aromen und das Verfahren zur Herstellung der Folie. Die die Erfindung betreffende Folie weist als kennzeichnende Merkmale eine Kernschicht C aus isotaktischem Polypropylen, eine corona-, flamm-, fluor- oder plasmavorbehandelte Außenschicht B aus einem olefinischen Homo-, Co-, oder Terpolymer oder eine Mischung der genannten Polymere und 0,01 bis 0,5 Gew.-% Antiblockpartikel mit guter, starker Haftung zum Aluminium, eine siegelfähige Schicht D aus einem olefinischen Homo-, Co- oder Terpolymer und 0,01 bis 0,5 Gew.-% Antiblockpartikel mit schlechter Haftung zum Aluminium, und eine im Vakuum auf die vorbehandelte Seite aufgedampfte Aluminiumschicht A auf.

Mit Metallen oder Metalloxiden bedampfte Polypropylenfolien werden wegen ihrer guten Sperreigenschaften gegen Wasserdampf, Sauerstoff, Licht und Aromen meist zur Verpackung von empfindlichen Lebensmittel eingesetzt. Die Folie muß ohne Probleme auch auf schnellaufenden Verpackungsmaschinen zu verarbeiten sein.

Der Einsatz von im Vakuum mit Aluminium bedampften biaxial orientierten Polypropylenfolien ist hinlänglich bekannt. Durch die Bedampfung wird die Barriere gegen Wasserdampf um den Faktor 10 und die Sauerstoffbarriere der Folie um den Faktor 100 verbessert. Weitere Verbesserungen gestalten sich zur Zeit schwierig, da die aufgedampfte Metallschicht Pinholes aufweist. Bei den Pinholes handelt es sich um eine große Anzahl sehr kleiner Löcher (ca. 1 µm Durchmesser) die nestartig auf der Metallschicht verteilt sind. Durch die Pinholes können erhebliche Mengen an Sauerstoff diffundieren, was sich negativ auf die Sauerstoffstoffbarriere auswirkt.

So ist in der EP-A 329336 eine metallisierbare Folie beschrieben, die gute Barrieeigenschaften hat. Allerdings ist aufgrund des hohen Homopolymeranteils in der zu metallisierenden Schicht die Haftung der aufgedampften Schicht zum Substrat für die heutigen Anforderungen nicht ausreichend. Hinzu kommt, daß die bedampfte Folie eine große Anzahl an Pinholes in der aufgedampften Metallschicht aufweist.

In der EP-A 395204 wird eine metallisierbare Folie beschrieben, die eine verbesserte Metalladhesion hat. Allerdings ist es nicht gelungen, das Pinholeproblem zu lösen. Deshalb hat diese Folie Nachteile bezüglich der Barrierewerte.

In der EP-A 481266 ist eine mehrschichtige, im Vakuum bedampfte Folie beschrieben, bei der im Vakuum nach der Metallbedamfung eine Schutzschicht aus Wachs auf das Metall gedampft wird. Diese Folie weist eine erheblich reduzierte Anzahl von Pinholes und verbesserte Barrierewerte auf. Allerdings führen die dort beschriebenen Wachse bei dem auf die Vakuumbeschichtung folgenden Verarbeitungsschritt (Kaschierung/Laminierung) besonders bei der Verwendung wässriger Klebersysteme zu Benetzungsproblemen. Darüber hinaus tritt die bei der Herstellung von Verbunden dem Stand der Technik entsprechende Verbesserung der Barrierewerte nicht auf (siehe Vergleichsbeispiel 3).

EP-A-282 917 betrifft eine metallisierbare, siegelfähige, biaxial streckorientierte Mehrschichtfolie umfassend eine Basisschicht im wesentlichen aus Polypropylen, eine erste polyolefinische Deckschicht und eine zweite polyolefinische Deckschicht, wobei alle Schichten als Neutralisations mittel ein Calciumcarbonat enthalten.

Daher erwies es sich als notwendig, eine metallisierte BOPP-Folie zu fertigen, die eine geringere Anzahl von Pinholes und damit verbesserte Barriereeigenschaften gegen Wasserdampf und Sauerstoff, gute Verarbeitungseigenschaften (Verklebung mit wasserbasierenden Klebern) aufweist.

Gelöst wird diese Aufgabe durch eine Folie gemäß Patentanspruch 1. Das bevorzugte Merkmal besteht darin, daß die mittels eines biaxialen Reckverfahrens hergestellte Folie eine im Vakuum bedampfbare, corona-, flamm-, plasma- oder fluorbehandelte Außenschicht B aus einem olefinischen Co- oder Terpolymer oder einem Blend zwischen mehreren olefinischen Co- oder Terpolymeren und einem Antiblockteilchen, welches eine gute Haftung zum aufgedampften Aluminium besitzt, eine Kernschicht C aus einem isotaktischen Polypropylen mit einem MFI zwischen 0,5 und 4,5 g/10 min und eine siegelfähige auf der nicht bedampften Seite liegende Außenschicht D aus einem olefinischen Co- oder Terpolymer und Antiblockteilchen, welche eine schlechte Haftung zum Aluminium besitzen, enthält. Überraschenderweise werden durch den Einsatz von Antiblockteilchen mit schlechter Haftung zum Aluminium, die sich auf der Bedampfung gegenüberliegenden Seite befinden, die bisher maßgeblich nur durch die Bedampfung beeinflußten Barrierwerte erheblich verbessert.

Um eine gute Maschinengängigkeit von biaxial orientierten Polypropylenfolien zu gewährleisten, ist es notwendig, mindestens die Siegel- bzw. Deckschichten mit Additiven auszustatten. Allerdings weisen im Vakuum bedampfte Folien, wenn sie mit Gleitmittel wie Erucasäureamid oder Polydimethylsiloxan ausgestattet sind, eine schlechte Haftung der aufgedampften Schicht gegenüber der Basisfolie auf. Um die Folie trotz fehlender Gleitmittel maschinengängig zu machen, ist es notwendig, die Außenschichten mit ausreichend vielen Antiblockteilchen auszustatten. Gängige Antiblockteilchen (mittlerer Teilchendurchmesser: 1 bis 5 µm, besonders bevorzugt: 2 bis 4 µm) mit guter Haftung zum Aluminium bestehen aus Siliciumdioxid, oder aus Alkalialuminiumsilikaten, oder aus Erdalkalialuminiumsilikate, oder aus vernetztem Polymethylmethacrylat, oder aus Polyamid. Besonders bevorzugt werden Erdalkalialuminiumsilikate mit einem mittleren Teilchendurchmesser von 2 bis 4 µm. Antiblockteilchen (mittlerer Teilchendurchmesser 1 bis 5 µm) mit naturgemäß schlechter Haftung sind vernetzte Olefine oder vernetzte Silikone, besonders bevorzugt werden Teilchen mit einem mittleren Durchmesser von 2 bis 4 µm.

Unter den zahlreichen, für siegelfähige und im Vakuum bedampfbare Schichten eingesetzten Materialien, werden folgende bevorzugt eingesetzt:

- statistische Propylen/Ethylen-Copolymere
- statistische Propylen/Olefin (1)-Copolymere
- statistische Propylen/Ethylen/Olefin-Terpolymere
- statistische Propylen/Olefin/Ethylen-Terpolymere
- Mischungen aus zwei oder drei der vorstehenden Polymere

Besonders bevorzugt wird ein Blend aus einem Propylen/Ethylen-Copolymer (90 bis 99 Gew.-%), dadurch gekennzeichnet, daß es 1,0 bis 10 Gew.-% Ethylen (bevorzugt 2 bis 6 Gew.-%) enthält und zwischen 110°C und 150°C, bevorzugt zwischen 120°C und 140 °C schmilzt, und einem Ethylen/octen-copolymer (1 bis 10 Gew.-%), welches dadurch gekennzeichnet ist, daß es eine Dichte <0,915 g/cm³ hat und 0,05 bis 0,35 Gew.-% eines Calciumaluminiumsilikates, dadurch gekennzeichnet, daß der mittlere Teichendurchmesser zwischen 1 und 3 µm liegt.

Besonders bevorzugt wird eine Mischung aus 99,95 bis 99,65 Gew.-% eines statistischen Propylen/Buten/Ethylen-polymers, dadurch gekennzeichnet, daß es einen MFI von 5 bis 10 g/10 min und einen Schmelzpunkt von 134°C hat und 0,05 bis 0,35 Gew.-% eines vernetzten Polydimethylsiloxanantiblockteilchen, dadurch gekennzeichnet, daß der mittlere Teilchendurchmesser zwischen 1 und 5 µm, besonders bevorzugt 2 bis 4 µm, liegt, enthält.

Die erfindungsgemäßen Folien können bevorzugt nach den üblichen Verfahren wie Laminierung, Beschichtung oder Schmelzcoextrusion hergestellt werden. Nach der Extrusion und der Verfestigung des Dickfilms erfolgt unterhalb des Kristallitschmelzpunktes der PP-Schicht eine biaxiale Orientierung. Die Orientierung kann sowohl simultan oder sequentiell erfolgen. Besonders bevorzugt wird folgendes Verfahren:

Nach der Verfestigung des Dickfilms auf der Gießwalze wird der Film in Laufrichtung (längs) mit einem Verstreckungsquotienten von 4/l bis 7/l bei einer Temperatur von 90°C bis 150°C (bevorzugt 110°C bis 140°C) gereckt. Das Reckverhältnis in Querrichtung liegt vorzugsweise zwischen 8/l und 12/l und das Querrecken des Filmes wird bei einer Temperatur zwischen 130°C und 170°C vorgenommen. Die nachfolgende Thermofixierung wird vorzugsweise bei 100°C bis 180°C (bevorzugt zwischen 150°C und 170°C) durchgeführt. Um die Affinität der weitgehend unpolaren Folienoberfläche zum Aluminium zu gewährleisten, ist es nötig, die Folie einer Corona-(Sprüh) Vorbehandlung zu unterziehen. Dabei wird der Luftsauerstoff in Form von Carbonyl-, Epoxid-, Ether- oder Alkoholgruppen auf der Folienoberfläche eingelagert. Weitere Methoden der Vorbehandlung von Polypropylenfolien sind die Flamm-, Plasma- und Fluorvorbehandlung.

**Beispiel 1**

Mittels des oben beschriebenen Herstellverfahrens wurde eine biaxial orientierte Folie (Flächenreckverhältnis: 45/l; Längsrecktemperatur: 142°C; Querrecktemperatur: 160°C) hergestellt, die folgenden Aufbau aufwies:
Gesamtdicke: 20 µm Schichtenfolge: ABCD
Definition der Schicht A siehe hinten.

| Deckschicht für die Bedampfung im Vakuum (B): | | |
|---|---|---|
| Dicke: 1 µm | | |
| Material: | | |
| 99,75 Gew.-% | Propylen/Ethylencopolymer | 3,5 Gew.-% Ethylen |
| | | MFI: 5,0 g/10 min |
| | | Dichte: 0,912 g/cm³ |
| 0,25 Gew.-% | Calciumaluminiumsilikat | mittlere Teilchengröße: 2,5 µm |

| Kernschicht (C): | | |
| --- | --- | --- |
| Dicke: 17 μm | | |
| Material: | | |
| 100 Gew.-% | isotaktisches Polypropylen | MFI: 3,0 g/10 min |

| Siegelschicht (D): | | |
| --- | --- | --- |
| Dicke: 2 μm | | |
| Material: | | |
| 0,25 Gew.-% | Propylen/Buten/Ethylencopolymer vernetzte Polydimethyl-siloxan-partikel | MFI: 7,0 g/10 min mittlere Teilchengröße: 2,0 μm |

**Vergleichsbeispiel 1**

Mittels des oben beschriebenen Herstellverfahrens wurde eine biaxial orientierte Folie (Flächenreckverhältnis: 45/l; Längsrecktemperatur: 142°C; Querrecktemperatur: 160°C) hergestellt, die folgenden Aufbau aufwies:
Gesamtdicke: 20 μm        Schichtenfolge: ABCD
Definition der Schicht A siehe hinten.

| Deckschicht für die Bedampfung im Vakuum (B): | | |
| --- | --- | --- |
| Dicke: 1 μm | | |
| Material: | | |
| 99,75 Gew.-% | Propylen/Ethylencopolymer | 3,5 Gew.-% Ethylenanteil MFI: 5,0 g/10 min |
| 0,25 Gew.-% | Calciumaluminiumsilikat | mittlere Teilchengröße: 2,5 μm |

| Kernschicht (C): | | |
| --- | --- | --- |
| Dicke: 17 μm | | |
| Material: | | |
| 100 Gew.-% | isotaktisches Polypropylen | MFI: 3,0 g/10 min |

| Siegelschicht (D): | | |
| --- | --- | --- |
| Dicke: 2 μm | | |
| Material: | | |
| 99,75 Gew.-% | Propylen/Ethylencopolymer | 3,5 Gew.-% Ethylenanteil MFI: 5,0 g/10 min |
| 0,25 Gew.-% | Calciumaluminiumsilikat | mittlere Teilchengröße: 2,5 μm |

**Vergleichsbeispiel 2**

Mittels des oben beschriebenen Herstellverfahrens wurde eine biaxial orientierte Folie (Flächenreckverhältnis: 45/1; Längsrecktemperatur: 142°C; Querrecktemperatur: 160°C) hergestellt, die folgenden Aufbau aufwies:
Gesamtdicke: 20 μm        Schichtenfolge: ABCD

| Deckschicht für die Bedampfung im Vakuum (B): | | |
|---|---|---|
| Dicke: 1 µm | | |
| Material: | | |
| 99,75 Gew.-% | Propylen/Ethylencopolymer | 3,5 Gew.-% Ethylenanteil<br>MFI: 5,0 g/10 min |
| 0,25 Gew.-% | vernetzte Polydimethyl-siloxan-teilchen | mittlere Teilchengröße: 2,0 µm |

| Kernschicht (C): | | |
|---|---|---|
| Dicke: 17 µm | | |
| Material: | | |
| 100 Gew.-% | isotaktisches Polypropylen | MFI: 3,0 g/10 min |

| Siegelschicht (D): | | |
|---|---|---|
| Dicke: 2 µm | | |
| Material: | | |
| 99,75 Gew.-% | Propylen/Ethylencopolymer | 3,5 Gew.-% Ethylenanteil<br>MFI: 5,0 g/10 min |
| 0,25 Gew.-% | vernetzte Polydimethyl-siloxan-teilchen | mittlere Teilchengröße: 2,0 µm |

**Vergleichsbeispiel 3**

Mittels des oben beschriebenen Herstellverfahrens wurde eine biaxial orientierte Folie (Flächenreckverhältnis: 45/l; Längsrecktemperatur: 142°C; Querrecktemperatur: 160°C) hergestellt. Dieses Muster wurde bei der Metallisierung im Vakuum inline mit einer die Aluminiumschicht (Schicht A) schützenden Wachsschicht W (siehe EP-A 481 266) bedampft.

Aufbau:

Gesamtdicke: 20 µm        Schichtenfolge: WABCD

| Deckschicht für die Bedampfung im Vakuum (B): | | |
|---|---|---|
| Dicke: 1 µm | | |
| Material: | | |
| 99,75 Gew.-% | Propylen/Ethylencopolymer | 3,5 Gew.-% Ethylenanteil<br>MFI: 5,0 g/10 min |
| 0,25 Gew.-% | Calciumaluminiumsilikat | mittlere Teilchengröße: 2,5 µm |

| Kernschicht (C): | | |
|---|---|---|
| Dicke: 17 µm | | |
| Material: | | |
| 100 Gew.-% | isotaktisches Polypropylen | MFI: 3,0 g/10 min |

| Siegelschicht (D): | | |
|---|---|---|
| Dicke: 1 µm | | |
| Material: | | |
| 99,75 Gew.-% | Propylen/Ethylencopolymer | 3,5 Gew.-% Ethylenanteil |
| | | MFI: 5,0 g/10 min |
| 0,25 Gew.-% | Calciumaluminiumsilikat | mittlere Teilchengröße: 2,5 µm |

Die in dem Beispiel und den Vergleichsbeispielen beschriebenen Folien wurden im Vakuum mit Aluminium bis zu einer optischen Dichte (OD) von 2,0 bedampft (Schicht A) und anschließend mit einer transparenten BOPP-Folie mittels eines wässrigen Dispersionsklebers auf Polyurethanbasis verklebt.

Unter der OD versteht man $OD = \lg \frac{Io}{I}$

wobei Io die Intensität des eingestrahlten Lichtes ist und I die Intensität des durch die Folie abgeschwächten Lichtes ist.

Folgende Tabelle zeigt, daß die erfindungsgemäße Folie den Folien mit symmertrischem Antiblockeinsatz und Folien mit der Wachsschutzschicht erheblich überlegen ist.

| | Pinholeanzahl | $O_2$-Du / $cm^3/m^2$d bar | $O_2$-du des Verbundes Muster/K/20µm BOPP | Verklebarkeit |
|---|---|---|---|---|
| Beispiel 1 | wenig | 62 | 8 | gut |
| Vergleich 1 | viel | 102 | 46 | gut |
| Vergleich 2 | mittel | 83 | 32 | gut |
| Vergleich 3 | wenig | 90 | 88 | schlecht |

**Meßverfahren**

Bestimmung der Sauerstoffdurchlässigkeit ($O_2$-Du):

Die Sauerstoffdurchlässigkeit wurde gemäß DIN 53380, Teil 3, bei 23°C und 0 % relative Luftfeuchte bestimmt.

Anzahl der Pinholes

Mittels einer Taschenlampe wird die Folie durchstrahlt und die Anzahl der Pinholes entsprechend folgender Einteilung beurteilt:
keine, wenig, mittel, viele

Bestimmung der Haftung der Antiblockteilchen zum Aluminium

Es wurden Folien hergestellt, die die Antiblockteilchen in der Konzentration 2 000 ppm/Siegelschicht enthalten. Diese Folien werden auf eine mit Aluminium bedampfte nicht coronavorbehandelte BOPP-Folie ohne Antiblockteilchen gelegt und bei 23°C über einen Zeitraum von 90 min mit einer Metallplatte und einem Gewicht derart belastet, daß die Gesamtmasse von Platte und Gewicht 1 kg beträgt. Nach dem Entfernen der Metallplatte und dem Abziehen der mit Antiblockteilchen ausgestatteten Folien von der mit Aluminium bedampften (nicht vorbehandelten) BOPP-Folie wird mittels Taschenlampe die Anzahl der Pinholes in der Aluminiumschicht beurteilt. Die Pinholeanzahl ist somit direkt mit der Haftung des Antiblockteilchens zum Aluminium korreliet. Es ergeben sich folgende Haftungseigenschaften:

| Antiblocktyp | Pinholeanzahl | Haftung zum Al |
|---|---|---|
| Calciumaluminiumsilikat | viele | gut |
| $SiO_2$ | viele | gut |
| vernetztes Polyethylen | wenig | schlecht |
| vernetztes Polydimethylsiloxan | wenig | schlecht |
| vernetztes PMMA | viele | gut |

EP 0 981 440 B1

Bestimmung des Schmelzflußindex (MFI)

Der Schmelzflußindex (im Text mit MFI abgekürzt) wurde in Anlehnung an DIN 53 735 bei 21.6 N Belastungskraft und einer Temperatur von 230°C gemessen.

Verklebarkeit:

Der kaschierte Verbund wird mindestens 3 Tage bei einem Klima von 23°C und 50 % rel. Feuchte gelagert. Danach wird der Verbund von Hand getrennt. Anhand des Verbleibs der Aluminiumschicht auf der ursprünglichen Folienseite oder auf der mittels Kleber aufkaschierten Folie wird der Verbund wie folgt eingeteilt.

Flächenmäßig weniger als 50 % aluminium haftet auf der mittels Kleber aufkaschierten Folienoberfläche: schlecht.

Flächenmäßig mehr als 50 % Aluminium haftet auf der mittels Kleber aufkaschierten Folienoberfläche: gut.

**Patentansprüche**

**1.** Biaxial orientierte, siegelfähige, mit Aluminium im Vakuum bedampfte Mehrschichtfolie weitgehend frei von migrirenden Additiven, die folgenden Aufbau aufweist:

        ABCD

wobei

    a) C die Kernschicht, aus isotaktischem Polypropylen mit einem MFI zwischen 0,5 und 4,5 g/10 min ist,

    b) B die Basisschicht für die Vakuumbedampfung aus 0,01 bis 0,5 Gew.-% eines organischen oder anorganischen Antiblockteilchen mit guter Haftung zum Aluminium und 99,5 bis 99,99 Gew.-% eines olefinischen Homo-, Co-, oder Terpolymer oder einer Mischung aus diesen olefinischen Poymeren ist sowie vor der Bedampfung mit Corona, Plasma, Flamme oder Fluor vorbehandelt ist,

    c) A die aufgedampfte Aluminiumschicht ist, wobei diese Aluminiumschicht den Lichtdurchgang um den Faktor 1/50 bis 1/500 abschwächt, und

    d) D die siegelfähige Schicht aus einem olefinischen Homo-, Co- oder Terpolymer und 0,01 bis 0,5 Gew.-% eines anorganischen oder organischen Antiblockteilchen ist,

**dadurch gekennzeichnet, daß** das Antiblockteilchen der Schicht D eine schlechtere Haftung zum Aluminium aufweist als das Antiblockteilchen der Schicht B.

**2.** Folie nach dem Anspruch 1, **dadurch gekennzeichnet, daß** die Antiblockteilchen eine mittlere Partikelgröße von 1 bis 5 μm besitzen.

**3.** Folie nach den Ansprüchen 1 oder 2, **dadurch gekennzeichnet, daß** die Folie als Solofolie oder Verbundfolienkomponente zu Verpackungzwecken eingesetzt wird.

**Claims**

**1.** A biaxially oriented, sealable multi-layer film, which is vacuum-metallised with aluminium and which is substantially free from migrating additives, and which has the following structure:

        A B C D

wherein

    a) C is the core layer, comprising isotactic polypropylene with an MFI between 0.5 and 4.5 g/10 min,

    b) B is the base layer for vacuum-metallising, comprising 0.01 to 0.5 % by weight of organic or inorganic antiseizing particles which exhibit good bonding to aluminium and 99.5 to 99.99 % of an olefinic homo-, co- or terpolymer or a mixture of said olefinic polymers, and before metallising is subjected to corona-discharge, plasma or flame pretreatment or pretreatment with fluorine,

c) A is the vapour-deposited aluminium layer, wherein said aluminium layer reduces the transmission of light by a factor of 1/50 to 1/500, and

d) D is the sealable layer, comprising an olefinic homo-, co- or terpolymer and 0.01 to 0.5 % by weight of inorganic or organic anti-seizing particles,

**characterised in that** the bonding of the anti-seizing particles of layer D to aluminium is inferior to that of the anti-seizing particles of layer B.

**2.** A film according to claim 1, **characterised in that** the anti-seizing particles have an average particle size of 1 to 5 µm.

**3.** A film according to claims 1 or 2, **characterised in that** the film is used as a single-component film or as a component of a composite film for packaging purposes.


**Revendications**

**1.** Feuille multicouche, métallisée au vide avec de l'aluminium, thermosoudable, orientée biaxialement, essentiellement exempte d'additifs migrants, qui présente la structure suivante :
ABCD
où

a) C est la couche centrale en polypropylène isotactique avec un MFI allant de 0,5 à 4,5 g/10 minutes ;
b) B est la couche de base pour la métallisation au vide, en 0,01 à 0,5% en poids de particules d'antiblocage organiques ou inorganiques ayant une bonne adhérence sur l'aluminium, et 99,5 à 99,99% en poids d'un homo-, co- ou terpolymère oléfinique ou un mélange de ces polymères oléfiniques, ainsi qu'elle est prétraitée avant la métallisation au vide, par Corona, au plasma, à la flamme ou au fluor ;
c) A est la couche en aluminium métallisée, où cette couche en aluminium affaiblit le passage de la lumière d'un facteur allant de 1/50 à 1/500, et
d) D est la couche thermosoudable en un homo-, co- ou terpolymère oléfinique et 0,01 à 0,5% en poids de particules d'antiblocage organiques ou inorganiques,

**caractérisée en ce que** les particules d'antiblocage de la couche D présentent une plus mauvaise adhérence sur l'aluminium que les particules d'antiblocage de la couche B.

**2.** Feuille suivant la revendication 1, **caractérisée en ce que** les particules d'antiblocage possèdent une taille moyenne des particules allant de 1 à 5 µm.

**3.** Feuille suivant la revendication 1 ou 2, **caractérisée en ce que** la feuille est mise en oeuvre, comme feuille individuelle ou comme feuille composant un composite, pour des objet d'emballage.